# EUROPEAN PATENT APPLICATION

(11) **EP 3 905 530 A1**
(43) Date of publication of application: **03.11.2021**
(21) Application number: 20172190.9
(22) Date of filing: 29.04.2020
(51) Int. Cl.: H03M 1/06, H03M 1/08, H03M 1/18

(54) **ANALOG-TO-DIGITAL CONVERSION DEVICE AS WELL AS METHOD FOR ANALOG-TO-DIGITAL CONVERSION**

(71) Applicant: Rohde & Schwarz GmbH & Co. KG, 81671 München (DE)
(72) Inventor: Troll, Peter, 81671 München (DE); Doeffinger, Dieter, 81671 München (DE); Biester, Michael, 81671 München (DE)
(74) Representative: Prinz & Partner mbB

(57) **Abstract**

An analog-to-digital conversion device (10) has an input (12), an output (14), a first conversion path (16), a second conversion path (18) and a control unit (20). The first conversion path (16) is connected to the input (12) as well as to the output (14) and comprises a first attenuator (22) and a first analog-to-digital converter (26) The second conversion path (18) is connected to the input (12) as well as to the output (14) and comprises a second attenuator (24) and a second analog-to-digital converter (28). The control unit (20) is connected to the first attenuator (22) and the second attenuator (24) and the control unit (20) is configured to control the first attenuator (22) and the second attenuator (24). Further, a method for analog-to-digital conversion is shown.

## Description

The invention concerns an analog-to-digital conversion device as well as a method for analog-to-digital conversion.

Even though digital signal processing leads to many advantages, the processing quality depends on the quality of the digitization of an analog signal into a digital representation of it. In particular, for analog signals having a high dynamic range, for example in radio frequency communication, efficient and high quality digitization poses a problem. Analog-to-digital converters having a wide input range are very expensive so that it is known to use an attenuator to attenuate the analog input signal if the analog input signal would overload the analog-to-digital converter. In this way, the dynamic range of the analog-to-digital converter may be reduced.

However, the use of an attenuator does create other quality problems, for example, the attenuator creates disturbances in the analog signal if the attenuation is switched or changed.

Thus, it is the object of the invention to provide an analog-to-digital conversion device as well as a method for analog-to-digital conversion that allows a high quality digitization of an analog signal with high dynamic range.

For this purpose, an analog-to-digital conversion device is provided comprising an input for an analog input signal to be converted, an output for a digital signal being a digital representation of the analog input signal to be converted, a first conversion path, a second conversion path and a control unit. The first conversion path is connected to the input as well as to the output and comprises a first attenuator and a first analog-to-digital converter. The second conversion path is connected to the input as well as to the output and comprises a second attenuator and a second analog-to-digital converter. The control unit is connected to the first attenuator and the second attenuator and the control unit is configured to control the first attenuator and the second attenuator.

By using two separate conversion paths with an attenuator and an analog-to-digital converter each, it is possible to perform necessary switching of an attenuator to adapt the attenuation in only one of the paths so that at any time an undisturbed signal is provided.

Thus, the advantages of an attenuator and analog-to-digital converter combination may be used but at the same time always providing a signal without disturbances. Even though more components are necessary, the proposed setup is in fact cheaper than a single analog-to-digital converter with a similar dynamic range.

In particular, the first and second path are parallel and separate from each other.

The control unit may be configured to control the first attenuator independently from the second attenuator.

For example, the analog-to-digital converters have a 14-bit word-length.

In an aspect, the first attenuator is located between the input and the first analog-to-digital converter and wherein the second attenuator is located between the input and the second analog-to-digital converter so that the analog input signal may be attenuated to make the best use of the dynamic range of the analog-to-digital converters.

The control unit may be a digital signal processing unit allowing a versatile control of the analog-to-digital conversion device.

In an embodiment the control unit comprises a first signal input connected to the first conversion path and a second signal input connected to the second conversion path, in particular wherein the first signal input is connected to an output of the first analog-to-digital converter and the second signal input is connected to an output of the second analog-to-digital converter. This way, the control unit is able to precisely control the analog-to-digital conversion device, in particular the first and/or second attenuator.

In particular, the control unit is configured to control the first and/or second attenuator based on the signals received at the first and/or second signal input.

The control may be such that the first attenuator is controlled based on the signals received at the first signal input and/or based on the signal received at the second signal input; and/or the control may be such that the second attenuator is controlled based on signal received at the second signal input and/or based on the signal received at the first signal input.

For example, the first signal input of the control unit is connected at a first connection point in the first conversion path located between the first analog-to-digital converter and the output, and/or wherein the second signal input is connected to a second connection point in the second conversion path located between the second analog-to-digital converter and the output.

In an embodiment, the first and/or second attenuator is a switchable digital step attenuator, in particular having predefined attenuation steps providing simple and reliable attenuation.

The attenuation steps may be 0db, 3db and 5db of attenuation.

For example, the first conversion path comprises a first signal multiplier and the second conversion path comprises a second signal multiplier, wherein the control unit is connected to the first and second signal multiplier and configured to control the first and second signal multiplier. This way, the signals in the first and/or second conversion path may be adapted easily.

In particular, the first and second signal multiplier may be controlled independently from one another.

In order to achieve signals in the conversion lines representing the analog input signal the closest, the control unit may be configured to control the first and/or second signal multiplier such that the attenuation currently applied by the respective one of the first and/or second attenuator is compensated; and/or such that differences in amplitude gain characteristics of the first and/or second conversion path are balanced.

For example, the first signal multiplier is located between the first analog-to-digital converter and the output and wherein the second signal multiplier is located between the second analog-to-digital converter and the output to make use of the advantages of digital signal processing.

In order to further improve the quality of the digital output signal, the first conversion path may comprise a first delay element and the second conversion path may comprise a second delay element, wherein the control unit is connected to the first and second delay element and configured to control the first and second delay element.

The first and second delay element may be controlled independently from one another.

In an aspect, the control unit is configured to control the first and second delay element such that run time differences of the first and second conversion path with respect to each other are compensated so that actions of the combiner to not result in a time step in the digital output signal.

In order to make use of the advantages of digital signal processing, the first delay element may be located between the first analog-to-digital converter and the output and wherein the second delay element may be located between the second analog-to-digital converter and the output.

In an embodiment, the output comprises a signal combiner for selecting the signal of the first conversion path or the second conversion path as the digital output signal of the analog-to-digital conversion device. In particular wherein the combiner is a switch, a summer or a differential summer. Thus, the digital output signal may be chosen from the signals of the first and second conversion path.

For example, the combiner is connected to the control unit and the control unit is configured to control the combiner, in particular based on the switching state of the first attenuator, the switching state of the second attenuator, the control settings for of the first and/or second attenuator, control setting for the first and/or second multiplier and/or the control settings for the first and/or second delay element. Thus, it can be assured by the control device that the digital output signal of the analog-to-digital conversion device is always without disturbances from switching the attenuators.

To allow for complex signal processing, the input, the output, the first conversion path and/or the second conversion path may comprise at least one filter.

The at least one filter may be in the analog or the digital domain. Further, the control unit may be configured to control the at least one filter.

Further, for above purpose a method for analog-to-digital conversion of an analog input signal is provided using an analog-to-digital conversion device, in particular an analog-to-digital conversion device as described above. The analog-to-digital conversion device comprises an input for the analog input signal to be converted, an output for a digital output signal being a digital representation of the analog input signal to be converted, a first conversion path, a second conversion path and a control unit, wherein the first conversion path is connected to the input as well as to the output and comprises a first attenuator and a first analog-to-digital converter, wherein the second conversion path is connected to the input as well as to the output and comprises a second attenuator and a second analog-to-digital converter. The method comprises the following steps:
a) determining an optimal attenuation for the analog input signal,
b) switching one of the first attenuator of the first conversion path and the second attenuator of the second conversion path to the optimal attenuation, and
c) at least during switching, selecting the digital signal of the first or second conversion path, in which the respective first or second attenuator is not being switched, as the digital output signal.

Thus, the digital output signal outputted via the output is free form disturbances generated by switching one of the attenuators. In particular, the steps are carried out by the control unit.

The method may further comprise the steps of determining which one of the first and second conversion path is the inactive path not providing the signal as the digital output signal and switching the respective attenuator of the inactive path.

The features and advantages discussed with respect to the analog-to-digital conversion device also apply to the method and vice versa. Further features and advantages will be apparent from the following description as well as the accompanying drawings, to which references made. In the drawings:
- Figure 1 shows schematically an analog-to-digital conversion device according to the invention,
- Figure 2 shows a flow chart of a method according to the invention, and
- Figure 3 illustrates the signal processing in the conversion paths on an exemplary signal.

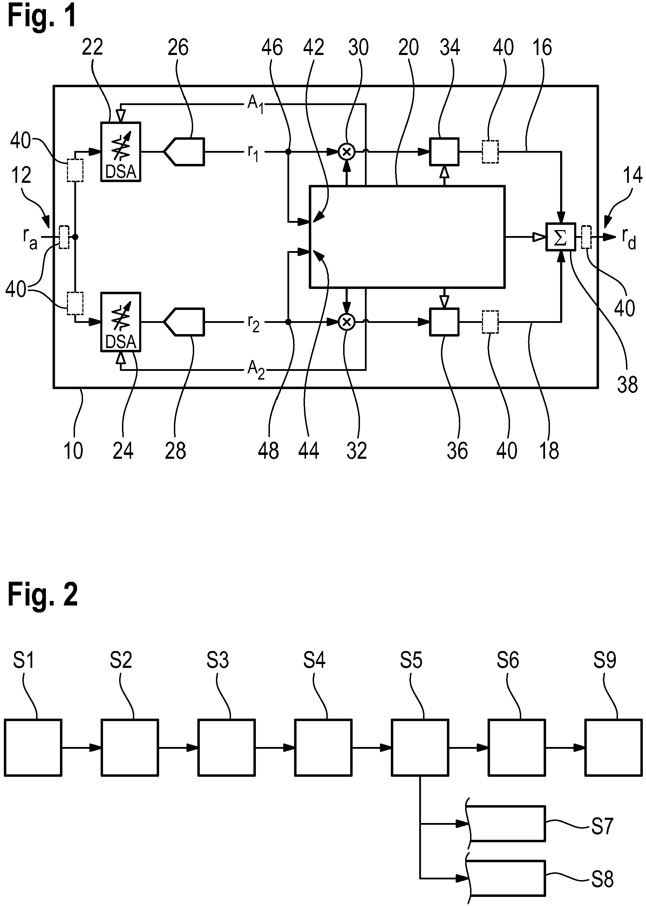

Figure 1 shows schematically an analog-to-digital conversion device 10 for digitizing an analog input signal rₐ, for example radio frequency signals in wireless communication systems.

The analog-to-digital conversion device 10 comprises an input 12, an output 14, a first conversion path 16, a second conversion path 18 and a control unit 20.

The input 12 is designed to receive the analog input signal rₐ to be converted, e.g. a radio frequency signal received by an antenna.

The output 14 is configured to provide a digital representation of the analog signal rₐ as a digital output signal r_{d}.

The output 14 may be connected to digital circuits for signal processing, for example of an oscilloscope or a communication device.

The input 12 is connected to the output 14 via each of the first conversion path 16 and the second conversion path 18.

Thus, the first conversion path 16 and the second conversion path 18 are separate from each other and parallel to each other. Each one of the conversion paths 16, 18 provides a signal connection from the input 12 to the output 14 independently from the other, except for interactions initiated by the control unit 20, which may be based on information of the other conversion path 16, 18.

The first conversion path 16 and the second conversion path 18 are configured identically.

The first conversion path 16 and the second conversion path 18 comprise a first attenuator 22 and a second attenuator 24, respectively, a first analog-to-digital converter 26 and a second analog-to-digital converter 28, respectively, a first signal multiplier 30 and a second signal multiplier 32, respectively, and a first delay element 34 and a second delay element 36, respectively.

The use of the words "first" and "second" before the various components of the conversion path 16 and 18 is for identification purposes only. The use of the word "second" for a component does not imply that there is a first component, i.e. two of the same components, in the same conversion path 16, 18.

In the shown embodiment, the output 14 comprises a signal combiner 38.

The first and second analog-to-digital converters 26, 28 divide the first and second conversion path 16, 18 in to an analog domain between the output 14 and the respective analog-to-digital converter 26, 28 and a digital domain between the respective analog-to-digital converter 26, 28 and the output 14.

The analog-to-digital converters 26, 28 may have a word-length of 14 bit.

The attenuators 22, 24 are located in the analog domain of the respective conversion path 16, 18, i.e. between the input 12 and the input of the respective analog-to-digital converter 26, 28.

The attenuators 22, 24 have predefined attenuation steps, for example 0db attenuation, 3db attenuation or 5db attenuation.

The first and/or second attenuator 22, 24 may be switchable digital step attenuators.

In the digital domain of each conversion path 16, 18 the respective signal multiplier 30, 32 and the respective delay element 34, 36 are arranged, i.e. they are located between the outputs of the respective analog-to-digital converters 26, 28 and the output 14 of the conversion device 10.

In the shown embodiment, the signal multipliers 30, 32 are located before, i.e. closer to the analog-to-digital converter 26, 28, the respective delay elements 34, 36.

Thus, the outputs of the delay elements 34, 36 are connected to the signal combiner 38.

The signal combiner 38 may be a switch, a summer or a differential summer.

Optionally, the conversion device 10 may comprise one or more filters 40, which may be arranged in the analog domain, then being analog filters, or in the digital domain, then being digital filters.

The filters 40 may be located in the input 12, the output 14 or in pairs in the first and second conversion path 16, 18. Of course, more than one filter 40 may be provided in each conversion path 16, 18 or the conversion device 10 in general. In Figure 1, the filters 40 are indicated by dashed minds.

The control unit 20 may be a digital signal processing unit for controlling the components of the conversion device 10.

The control unit 20 is connected to and configured to control to each one of the first and second attenuators 22, 24, of the first and second signal multipliers 30, 32, of the first and second delay elements 34, 36 and of the signal combiner 38.

The control unit 20 further comprises a first signal input 42 and a second signal input 44. The first signal input 42 is connected to the first conversion path 16 in the digital domain, i.e. it is connected to the output of the first analog-to-digital converter 26. This may be done at a first connection point 46 located between the first analog-to-digital converter 26 and the first signal multiplier 30.

Likewise, the second signal input 44 is connected to the second conversion path 18 in the digital domain, namely to the output of the second analog-to-digital converter 28. This connection may be done with a second connection point 48 located between the second analog-to-digital converter 28 and the second signal multiplier 32.

The control unit 20 is configured to control each of the components 22, 24, 30, 32, 34, 36, 38 and optionally filters 40 independently from one another, meaning in particular that the components 22, 30, 34 of the first conversion path 16 may be controlled independently of the components 24, 32, 36 of the second conversion path 18.

The control unit 20 control the components 22, 24, 30, 32, 34, 36, 38 and optionally filter 40 based on the signals r₁, r₂ and/or at least one state or control setting of the other components22, 24, 30, 32, 34, 36, 38 and optionally filter 40, i.e. the switching state of the first attenuator 22; the switching state of the second attenuator 24; the control settings for of the first and/or second attenuator 22, 24; control setting for the first and/or second signal multiplier 30, 32; and/or the control settings for the first and/or second delay element 34, 36.

The control setting corresponds to the state of the component, as the state of the component is controlled by the control unit 20. However, in some components the actual state of the components is not detected.

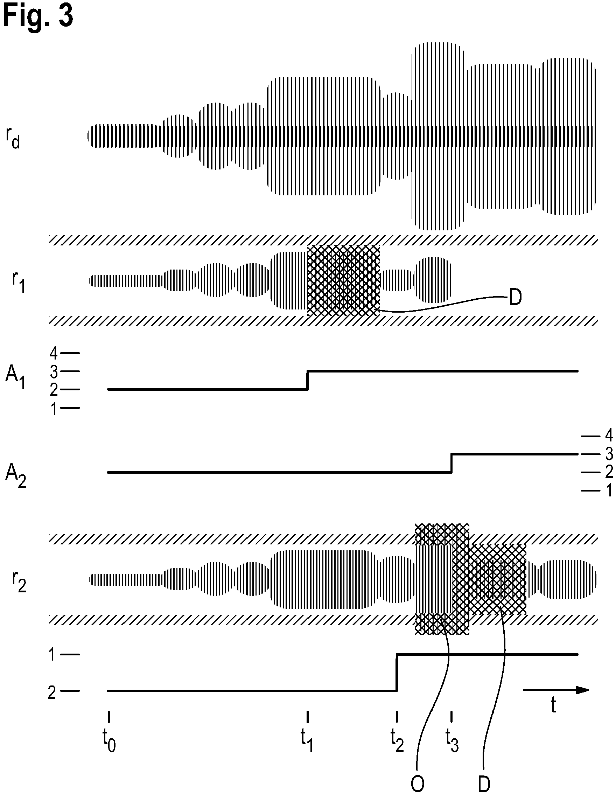

For efficient and disturbance free conversion of the analog signal rₐ into the digital signal r_{d}, the control unit 20 controls the conversion device 10 as illustrated in Figures 2 and 3.

In general, the control is done based on the signal r₁ after first conversion path 16 received at the first signal input 42 and the signal r₂ of the second conversion path 18 received at the second signal input 44 by the control unit 20.

Figure 2 shows a flow chart of a method for analog-to-digital conversion and Figure 3 illustrates an example of the various signals in the conversion device 10 over time.

In a first step S1, the analog input signal rₐ is received by the input 12 and provided to the first conversion path 16 and the second conversion path 18, respectively.

The signals then pass the respective attenuator 22, 24 and are converted in to digital signals r₁, r₂ by the respective analog-to-digital converter 26, 28.

In step S2, the control unit 20 receives the digitized signals r₁, r₂ via the first and second signal input 42, 44.

The control unit 20 then determines for at least one of the conversion paths 16, 18 an optimal attenuation for the analog signal rₐ. The optimal attenuation corresponds to the amount of attenuation that leads to an attenuated signal, which uses the dynamic range of the analog-to-digital converters 26, 28 most widely, without leaving the dynamic range, i.e. without overloading the analog-to-digital converter 26, 28.

The attenuators 22, 24 may have different attenuation steps A₁, A₂, in the shown example four different attenuation steps.

As can been in Figure 3, in the beginning of the example at t₀ both attenuators 22, 24 use the second attenuation step so that both signals r₁, r₂ in the first conversion path 16 and the second conversion path 18 are identical.

On the bottom of Figure 3, the state of the signal combiner 38 is illustrated. In the shown example, the signal combiner 38 is a simple switch that may select the first conversion path 16 or the second conversion path 18 to provide the digital output signal r_{d} of the analog-to-digital conversion device 10.

At t₀, the signal r₂ of the second conversion path 18 is outputted as the digital signal r₂ by the signal combiner 38 and thus the output 14.

For ease of explanation, the conversion path 16, 18 which is selected by the signal combiner 38 to provide the digital output signal r_{d} is called the active conversion path and the other conversion path 16, 18 the inactive conversion path.]

As the magnitude of the signal increases, the control unit 20 determines at t₁ that attenuation step 3 would be more suitable as the analog-to-digital converters 26, 28 are close to overloading.

In step S4, the control unit sends then a control setting indicating the optimal attenuation step A₁ to the first attenuator 22 being in the inactive conversion path so that the first attenuator 22 switches to the optimal attenuation A₁.

When switching from one attenuation step A₁ to another attenuation step A₁, the first attenuator 22 creates a disturbance D of the signal r₁ in the first conversion path 16 (indicated by the hatched area in Figure 3).

To avoid that the disturbance D disturbs the digital output signal r_{d}, the control unit 20 controls the signal combiner 38 such that the signal of the second conversion path 18 is outputted as the digital signal r_{d} at the output 14. In this case, as the signal combiner 38 is already switched to the second conversion path 18, no action is needed.

In general, during switching of one of the attenuators 22, 24 the control unit 20 controls the signal combiner 38 as to select the signal r₁, r₂ as the digital output signal r_{d} of the conversion path 16, 18 in which the attenuator 22, 24 is not being switched (step S5).

In other words, the control unit 20 controls the attenuators 22, 24 such that only the attenuator 22, 24 of the inactive conversion path is switched and that the attenuator 22, 24 of the active conversion path does not perform switching as long as the corresponding conversion path remains active.

After switching of the attenuator 22, the control unit 20 controls the signal combiner 38 to provide the signal r₁ of the first conversion path 16 as the digital output signal r_{d} at t₂.

To avoid any disturbances in the digital output signal r_{d} due to the switching of the signal combiner 38, the control unit 20 controls the signal multipliers 30, 32 such that the amplitude of the signals r₁, r₂ of the first conversion path 16 and the second conversion path 18 are identical (step S7), and in particular that the effects of the respective ones of the first and second attenuator 22, 24 are compensated.

Thus, after the signal multipliers 30, 32, the signals r₁, r₂ of the first and second conversion path 16, 18 represent the amplitude of the analog input signal rₐ.

With the signal multipliers 30, 32 also any gain characteristics of the first and/or second conversion path 16, 18 are compensated.

In step S8 the control unit 20 controls the delay elements 34, 36 such that any run time differences between the first conversion path 16 and the second conversion path are compensated.

Steps S7 and S8 are carried out simultaneously to step S6 or start beforehand to avoid any noticeable effects on the digital output signal r_{d} during switching of the signal combiner 38. Of course, steps S7 and S8 may be performed continuously and independently from any switching of the signal combiner 38.

After the signal combiner 38 has been switched, the first conversion path 16 is the active conversion path and signal r₁ is outputted as the digital output signal r_{d}, which has now a higher conversion quality as the attenuation of the first attenuator 22 of the first conversion path 16 has been set to optimal values.

Once the second conversion path 18 is no longer the active path but now the inactive conversion path, the control unit 20 may control the second attenuator 24 to switch the attenuation step A₂ to step 3 at time t₃ as well to avoid overloading effects as indicated by the hatched area O in Figure 3 (step S9).

None of the occurring switching disturbances D influences the digital output signal of the conversion device 10, as the first conversion path 16 is the active path.

Of course, if the amplitude of the analog input signal rₐ decreases and thus the attenuation of the attenuators 22, 24 is too high, the control unit 20 creates control signals A₁ for the attenuators 22, 24 to reduce the attenuation step A₁, A₂ based on the signals r₁, r₂ received at the first and second signal input 42, 44.

This way, the dynamic range of the analog-to-digital converters 26, 28 can be used to the greatest extend possible at any time.

The switching scheme remains the same as explained above, i.e. switching of the attenuators 22, 24 occurs only on the inactive conversion path. The control unit 20 may use both signals r₁ and r₂ to determine the attenuation of each of the attenuators 22, 24.

Of course, the control unit 20 may also control any filter 40 of the conversion device 10.

Thus, the analog-to-digital conversion device 10 provides a digital output signal r_{d} without any disturbances even though the analog input signal rₐ may have a very wide dynamic range necessitating the use of an attenuator before an analog-to-digital converter.

## Claims

1. Analog-to-digital conversion device comprising an input (12), an output (14), a first conversion path (16), a second conversion path (18) and a control unit (20),
wherein the first conversion path (16) is connected to the input (12) as well as to the output (14) and comprises a first attenuator (22) and a first analog-to-digital converter (26),
wherein the second conversion path (18) is connected to the input (12) as well as to the output (14) and comprises a second attenuator (24) and a second analog-to-digital converter (28), and
wherein the control unit (20) is connected to the first attenuator (22) and the second attenuator (24) and the control unit (20) is configured to control the first attenuator (22) and the second attenuator (24).

2. Analog-to-digital conversion device according to claim 1, **characterized in that** the first attenuator (22) is located between the input (12) and the first analog-to-digital converter (26) and wherein the second attenuator (24) is located between the input (12) and the second analog-to-digital converter (26).

3. Analog-to-digital conversion device according to claim 1 or 2, **characterized in that** the control unit (20) is a digital signal processing unit.

4. Analog-to-digital conversion device according to any one of the preceding claims, **characterized in that** the control unit (20) comprises a first signal input (42) connected to the first conversion path (16) and a second signal input (44) connected to the second conversion path (18), in particular wherein the first signal input (42) is connected to an output of the first analog-to-digital converter (26) and the second signal input (44) is connected to an output of the second analog-to-digital converter (28).

5. Analog-to-digital conversion device according to any one of the preceding claims, **characterized in that** the first and/or second attenuator (22, 24) is a switchable digital step attenuator, in particular having predefined attenuation steps.

6. Analog-to-digital conversion device according to any one of the preceding claims, **characterized in that** the first conversion path (16) comprises a first signal multiplier (30) and the second conversion path (18) comprises a second signal multiplier (32), wherein the control unit (20) is connected to the first and second signal multiplier (30, 32) and configured to control the first and second signal multiplier (30, 32).

7. Analog-to-digital conversion device according to claim 6, **characterized in that** the control unit (20) is configured to control the first and/or second signal multiplier (30, 32) such that the attenuation currently applied by the respective one of the first and/or second attenuator (22, 24) is compensated; and/or such that differences in amplitude gain characteristics of the first and/or second conversion path (16, 18) are balanced.

8. Analog-to-digital conversion device according to claim 6 or 7, **characterized in that** the first signal multiplier (30) is located between the first analog-to-digital converter (26) and the output (14), and/or wherein the second signal multiplier (32) is located between the second analog-to-digital converter (28) and the output (14).

9. Analog-to-digital conversion device according to any one of the preceding claims, **characterized in that** the first conversion path (16) comprises a first delay element (34) and the second conversion path (18) comprises a second delay element (36), wherein the control unit (20) is connected to the first and second delay element (34, 36) and configured to control the first and second delay element (34, 36).

10. Analog-to-digital conversion device according to claim 9, **characterized in that** the control unit (20) is configured to control the first and second delay element (34, 36) such that run time differences of the first and second conversion path (16, 18) with respect to each other are compensated.

11. Analog-to-digital conversion device according to claim 9 or 10, **characterized in that** the first delay element (34) is located between the first analog-to-digital converter (26) and the output (14) and wherein the second delay element (36) is located between the second analog-to-digital converter (28) and the output (14).

12. Analog-to-digital conversion device according to any one of the preceding claims, **characterized in that** the output (14) comprises a signal combiner (38) for selecting the signal (r₁, r₂) of the first conversion path (16) or the second conversion path (18) as the digital output signal (r_{d}) of the analog-to-digital conversion device (10), in particular wherein the signal combiner (38) is a switch, a summer or a differential summer.

13. Analog-to-digital conversion device according to claim 12, **characterized in that** the signal combiner (38) is connected to the control unit (20) and the control unit (20) is configured to control the signal combiner (38), in particular based on the switching state of the first attenuator (22); the switching state of the second attenuator (24); the control settings for of the first and/or second attenuator (22, 24); control setting for the first and/or second signal multiplier (30, 32); and/or the control settings for the first and/or second delay element (34, 36).

14. Analog-to-digital conversion device according to any one of the preceding claims, **characterized in that** the input (12), the output (14), the first conversion path (16) and/or the second conversion path (18) comprises at least one filter (40).

15. Method for analog-to-digital conversion of an analog input signal (rₐ) using an analog-to-digital conversion device (10), in particular an analog-to-digital conversion device (10) according to any one of the preceding claims,
the analog-to-digital conversion device (10) comprising an input (12) for the analog input signal (rₐ), an output (14) for a digital output signal (r_{d}) being a digital representation of the analog signal (rₐ) to be converted, a first conversion path (16), a second conversion path (18) and a control unit (20), wherein the first conversion path (16) comprises a first attenuator (22) and a first analog-to-digital converter (26), wherein the second conversion path (18) comprises a second attenuator (24) and a second analog-to-digital converter (28), the method comprising the following steps:
a) determining an optimal attenuation for the analog input signal (rₐ),
b) switching one of the first attenuator (22) of the first conversion path (16) and the second attenuator (24) of the second conversion path (18) to the optimal attenuation, and
c) at least during switching, selecting the digital signal (r₁, r₂) of the first or second conversion path (16, 18), in which the respective first or second attenuator (22, 24) is not being switched, as the digital output signal (r_{d}).
